# EUROPÄISCHE PATENTANMELDUNG

(11) **EP 3 660 497 A1**
(43) Veröffentlichungstag der Anmeldung: **03.06.2020**
(21) Anmeldenummer: 18208574.6
(22) Anmeldetag: 27.11.2018
(51) Int. Cl.: G01N 27/12, G01N 27/414, H01L 29/00, H01L 29/66, H01L 29/06, B82Y 15/00

(54) **NANOPARTIKELBASIERTES HALBLEITER-STRUKTURELEMENT BEINHALTEND EINEN PN-ÜBERGANG**

(71) Anmelder: FRAUNHOFER-GESELLSCHAFT zur Förderung der angewandten Forschung e.V., 80686 München (DE)
(72) Erfinder: KLUMPP, Armin, 80337 München (DE)
(74) Vertreter: Schenk, Markus

(57) **Zusammenfassung**

Die vorliegende Erfindung betrifft ein nanopartikelbasiertes Halbleiter-Strukturelement (10) mit einer ersten Nanopartikelstruktur (11) mit einer Vielzahl von ersten Nanopartikeln (11₁, 11₂, 11₃) und einer zweiten Nanopartikelstruktur (12) mit einer Vielzahl von zweiten Nanopartikeln (12₁, 12₂, 12₃). Die erste Nanopartikelstruktur (11) und die zweite Nanopartikelstruktur (12) sind direkt aneinander angrenzend angeordnet, sodass zumindest ein Teil der ersten Nanopartikel (11₁, 11₂, 11₃) und zumindest ein Teil der zweiten Nanopartikel (12₁, 12₂, 12₃) in direktem Kontakt miteinander sind, wobei sich an den jeweiligen Kontaktpunkten von ersten und zweiten Nanopartikeln (11₁, 11₂, 11₃, 12₁, 12₂, 12₃) ein p-n-Übergang mit einer vorbestimmten Raumladungszone ausbildet.

## Beschreibung

Die Erfindung betrifft ein Halbleiter-Strukturelement, und insbesondere ein nanopartikelbasiertes Halbleiter-Strukturelement.

Halbleiterschaltungen sind hinlänglich bekannt und weisen mindestens ein halbleitendes Material und mindestens einen p-n-Übergang auf. Eine oder mehrere derartige Halbleiterschaltungen können in Halbleiterstrukturen integriert sein. Diese Halbleiterstrukturen können eindimensionale, zweidimensionale oder dreidimensionale Formen aufweisen und daher auch als Halbleiter-Strukturelemente bezeichnet werden. Diese werden für gewöhnlich eingesetzt, um beispielsweise elektronische Bauteile herzustellen. Beispielsweise werden derartige Halbleiter-Strukturelemente heutzutage im Bereich der Sensorik genutzt. Aufgrund der geringen, und teilweise mikroskopisch kleinen Abmessungen halbleiterbasierter Sensoren sind die erzeugbaren Signalpegel verhältnismäßig gering. Daher müssen derartige Halbleiter-Strukturelemente hochpräzise gefertigt werden, was jedoch mit hohen Herstellungskosten verbunden ist.

Außerdem müssen die sehr geringen Signalpegel in der Regel verstärkt werden, bevor die Signale ausgewertet werden können. Bei der auf Halbleitertechnik basierenden Detektion von Licht wird beispielsweise eine intrinsische Verstärkung durch Avalanche-Vervielfältigung von elektrischen Ladungsträgern verwendet. Dort liegt eine Beschleunigungsspannung über einem Bauelementbereich, in dem durch Licht die elektrischen Ladungsträger erzeugt und durch nachfolgende ionisierende Stöße vervielfältigt werden. Dies lässt sich allerdings so nicht auf die elektrochemische Sensorstruktur übertragen.

Bei der chemischen Sensorik kann das Prinzip der intrinsischen Verstärkung hingegen nicht ohne weiteres adaptiert werden. Je nachdem auf welchen chemischen Bestandteil die halbleiterbasierte Sensorik responsiv sein soll, müssen bei der Herstellung eines konventionellen chemischen Halbleiter-Sensors teilweise sehr hohe Prozessierungstemperaturen (> 600°C) angewendet werden, um geeignete stöchiometrische Verbindungen zu schaffen. Bei diesen hohen Prozessierungstemperaturen besteht jedoch die Gefahr, dass die halbleiterbasierte Sensorschicht irreparabel geschädigt wird. Außerdem würden, je nachdem welcher chemische Bestandteil gemessen werden soll, Materialverbindungen benötigt, die jedoch aufgrund inkompatibler konventioneller Herstellungsprozesse nicht miteinander kombinierbar sind, wie z.B. oxidische Schichten mit einer dazwischen angeordneten Sulfidschicht. Aus diesem Grund wird im Bereich der halbleiterbasierten chemischen Sensorik heutzutage nicht mit intrinsischer Verstärkung sondern mit einer nachgeschalteten Verstärkung des Sensorsignals gearbeitet, z.B. unter Verwendung von geeigneten Verstärkerschaltungen und mit einer möglichst rauscharmen proportionalen Signalvervielfachung.

Es wäre demnach wünschenswert, ein Halbleiter-Strukturelement bereitzustellen, das diverse Materialkombinationen ermöglicht, um einen breiten Einsatzbereich abzudecken, und dabei trotzdem kostengünstig herstellbar ist und gleichzeitig eine hohe Signalqualität liefert.

Daher wird ein Halbleiter-Strukturelement mit den Merkmalen von Anspruch 1 vorgeschlagen. Ausführungsformen und weitere vorteilhafte Aspekte dieses Halbleiter-Strukturelements sind in den jeweils abhängigen Patentansprüchen genannt.

Das erfindungsgemäße Halbleiter-Strukturelement basiert auf Nanopartikeln. Nanopartikel, die auch als Nanoteilchen bezeichnet werden können, definieren sich durch ihre Größe, die typischerweise zwischen 1 bis 100 Nanometern liegt. Das Halbleiter-Strukturelement hat eine eindimensionale, zweidimensionale oder dreidimensionale Form und weist eine Vielzahl derartiger Nanopartikeln auf. Genauer gesagt weist das Halbleiter-Strukturelement eine erste Nanopartikelstruktur mit einer Vielzahl von ersten Nanopartikeln, sowie eine zweite Nanopartikelstruktur mit einer Vielzahl von zweiten Nanopartikeln auf. Die Nanopartikel können innerhalb der jeweiligen Nanopartikelstruktur lose vorliegen oder fest miteinander verbunden sein. Die Nanopartikelstrukturen können beispielsweise in Form einer Schicht, eines Flake-Körpers oder anderer Strukturen vorliegen. Die Nanopartikelstrukturen können demnach ihrerseits ganz allgemein eine eindimensionale, zweidimensionale oder dreidimensionale Form aufweisen. Erfindungswesentlich ist jedoch, dass die erste Nanopartikelstruktur und die zweite Nanopartikelstruktur direkt aneinander angrenzend angeordnet sind, und zwar so, dass zumindest ein Teil der ersten Nanopartikel und zumindest ein Teil der zweiten Nanopartikel in direktem Kontakt miteinander sind. Dies führt dazu, dass sich an den jeweiligen Kontaktpunkten von ersten und zweiten Nanopartikeln ein p-n-Übergang mit einer vorbestimmten Raumladungszone ausbildet. Gleichbedeutend mit einem p-n-Übergang ist selbstverständlich auch ein n-p-Übergang, der somit ebenfalls im Sinne der vorliegenden Offenbarung eingeschlossen ist. Die vorbestimmte Raumladungszone zwischen den beiden Nanopartikelstrukturen bedingt einen entsprechend vorbestimmten Leitwert des Halbleiter-Strukturelements. Die Nanopartikel innerhalb der Nanopartikelstrukturen führen dazu, dass die jeweilige Nanopartikelstruktur ein verhältnismäßig großes Oberflächen-Volumen-Verhältnis aufweist. Demnach bieten die Nanopartikelstrukturen eine deutliche größere aktive Oberfläche im Vergleich zu konventionellen Halbleiterstrukturen bei gleichem Volumen. Aufgrund der erhöhten aktiven Oberfläche weist das erfindungsgemäße nanopartikelbasierte Halbleiter-Strukturelement eine deutlich höhere Empfindlichkeit im Vergleich zu konventionellen, gleich großen, Halbleiterstrukturen auf. Ein weiterer Vorteil der Nanopartikelstrukturen besteht darin, dass ein einfacher physischer Kontakt zwischen der ersten und der zweiten Nanopartikelstruktur bereits ausreichend ist, um an der Kontaktstelle einen p-n-Übergang auszubilden. Das heißt, die im Stand der Technik üblichen hohen Prozessierungstemperaturen (> 600°C), die zum Herstellen von stöchiometrischen Verbindungen zwischen zwei konventionellen (nicht nanopartikelbasierten) Halbleitermaterialien benötigt werden, können vermieden werden. Zudem können mit der vorliegenden Erfindung auch Verbindungen von Materialien, die ansonsten aufgrund nicht-kompatibler Herstellungsprozesse nicht oder nur unter erschwerten Bedingungen miteinander kombinierbar wären, realisiert werden.

Gemäß einem Ausführungsbeispiel kann die erste Nanopartikelstruktur und/oder die zweite Nanopartikelstruktur eine diffusionsoffene (innere) Struktur aufweisen, in welche Moleküle aus der Umgebung eindiffundieren können. Wie eingangs erwähnt, können die Nanopartikel innerhalb der jeweiligen Nanopartikelstruktur derart aneinander angelagert sein, dass sich eine poröse Struktur ausbildet. Demnach kann die gesamte Nanopartikelstruktur innen sowie außen eine poröse Struktur aufweisen. Dies wiederum erhöht das Oberflächen-Volumen-Verhältnis der aktiven, inneren Oberfläche der jeweiligen Nanopartikelstruktur.

Gemäß einem weiteren Ausführungsbeispiel kann das nanopartikelbasierte Halbleiter-Strukturelement derart ausgestaltet sein, dass sich die vorbestimmte Raumladungszone und somit ein vorbestimmter Leitwert des nanopartikelbasierten Halbleiter-Strukturelements verändert, wenn sich eindiffundierte Moleküle an der Oberfläche von in der jeweiligen Nanopartikelstruktur enthaltenen Nanopartikeln anlagern. Die sich anlagernden Moleküle beeinflussen somit direkt den p-n-Übergang zwischen sich gegenseitig kontaktierenden Nanopartikeln der ersten und zweiten Nanopartikelstrukturen. Das heißt, die Raumladungszone des p-n-Übergangs wird größer oder kleiner. Dies führt dementsprechend zu einer Änderung des Leitwerts des Halbleiter-Strukturelements, d.h. der Leitwert wird ebenfalls größer oder kleiner. Aufgrund des großen Oberflächen-Volumen-Verhältnisses der Nanopartikelstrukturen können sich (im Vergleich zu konventionellen, nicht nanopartikelbasierten Halbleiterstrukturen) relativ viele Moleküle an der aktiven Oberfläche anlagern. Je mehr Moleküle sich an der aktiven Oberfläche anlagern, desto stärker fällt die Änderung des Leitwerts aus. Dies kann vorteilhaft für elektrochemische Sensorik verwendet werden.

Gemäß einem weiteren Ausführungsbeispiel kann das Halbleiter-Strukturelement eine Auswerteschaltung aufweisen oder mit einer solchen verbunden werden, wobei die erste und/oder die zweite Nanopartikelstruktur eine elektrochemische Sensorstruktur bereitstellt, wobei Moleküle eines Analyten in diese elektrochemische Sensorstruktur eindiffundieren und sich an der Oberfläche von darin befindlichen Nanopartikeln anlagern können, um die vorbestimmte Raumladungszone und somit einen vorbestimmten Leitwert des nanopartikelbasierten Halbleiter-Strukturelements zu verändern, und wobei die Auswertevorrichtung ausgestaltet ist, um basierend auf der Änderung des Leitwerts den Analyten zu bestimmen. Wie eingangs erwähnt, kann also mittels des erfindungsgemäßen Halbleiter-Strukturelements ein elektrochemischer Sensor realisiert werden. Die erste und/oder zweite Nanopartikelstruktur können dabei eine elektrochemische Sensorschicht bereitstellen, an der sich Moleküle eines Analyten anlagern können. Je nach Typ des Analyten stellt sich ein anderer Leitwert ein, anhand dessen der Analyt bestimmt werden kann. Da sich aufgrund der porösen Struktur der Nanopartikelstrukturen verhältnismäßig viele Moleküle an der aktiven Oberfläche anlagern können, können auch unterschiedliche Typen von Analyten mit hoher Genauigkeit bzw. Empfindlichkeit bestimmt und voneinander unterschieden werden.

Gemäß einem weiteren Ausführungsbeispiel kann das nanopartikelbasierte Halbleiter-Strukturelement ausgestaltet sein, um ein Signal mit intrinsisch nicht-linearer Verstärkung zu erzeugen. Das heißt, das erfindungsgemäße Halbleiter-Strukturelement benötigt im Vergleich zu konventionellen, nicht nanopartikelbasierten, Halbleitern keine extrinsische Signalverstärkung. Zudem kann die sich an den einzelnen Nanopartikeln ausbildende Vielzahl von p-n-Übergängen dafür sorgen, dass es zu einer nicht-linearen Signalverstärkung kommt. Beispielsweise kann eine sich selbst verstärkende Signalverstärkungswirkung eintreten, vergleichbar mit dem Avalanche-Effekt bei Photodioden.

Gemäß einem weiteren Ausführungsbeispiel können die ersten Nanopartikel der ersten Nanopartikelstruktur und die zweiten Nanopartikel der zweiten Nanopartikelstruktur jeweils unterschiedliche Materialien aufweisen, die sich in der Höhe der Austrittsarbeiten für Elektronen und/oder in der Höhe der jeweiligen Bandlücke voneinander unterscheiden. Das heißt, das Halbleiter-Strukturelement weist einen heterogenen Aufbau auf, wobei die ersten Nanopartikel der ersten Nanopartikelstruktur und die zweiten Nanopartikel der zweiten Nanopartikelstruktur unterschiedliche Materialien aufweisen können. Diese unterschiedlichen Materialien sind vorzugsweise unterschiedliche Halbleitermaterialien, sodass es an den Kontaktstellen zwischen den Nanopartikeln unterschiedlicher Materialien zu elektronischen Übergängen mit p-n-Charakteristik bzw. n-p-Charakteristik kommt.

Gemäß einem weiteren Ausführungsbeispiel können die ersten Nanopartikel der ersten Nanopartikelstruktur und die zweiten Nanopartikel der zweiten Nanopartikelstruktur jeweils unterschiedliche Materialien aus der chemischen Hauptgruppe VI, die auch als Chalkogene bezeichnet werden, aufweisen. Hierzu zählen Sauerstoff (O), Schwefel (S), Selen (Se), Tellur (Te), sowie Polonium (Po) und Livermorium (Lv).

Gemäß einem weiteren Ausführungsbeispiel können die ersten Nanopartikel der ersten Nanopartikelstruktur und die zweiten Nanopartikel der zweiten Nanopartikelstruktur jeweils unterschiedliche Materialverbindungen mit jeweils mindestens einem Element der chemischen Hauptgruppe VI und mindestens einem Übergangsmetall aufweisen, wobei diese Materialverbindungen auch als Chalkogenide bezeichnet werden und die elektrische Leitfähigkeit von Halbleitern aufweisen. Chalkogenide sind chemische Verbindungen aus einem oder mehreren Chalkogen-Elementen (insbesondere Sauerstoff, Schwefel, Selen und Tellur) als formale Anionen mit Metallen oder stärker elektropositiven Elementen (Arsen, Germanium, Phosphor, Antimon, Blei, Bor, Aluminium, Gallium, Indium, Titan, Natrium) als formale Kationen. Für die erfindungsgemäßen Nanopartikelstrukturen werden vorzugsweise Übergangsmetalle als Reaktionspartner mit den Chalkogen-Elementen verwendet, da diese eine Elektronenkonfiguration besitzen, so dass sich eine halb-leitende Eigenschaft der Materialverbindung einstellt. Die chemischen Elemente mit den Ordnungszahlen von 21 bis 30, 39 bis 48, 57 bis 80 und 89 bis 112 werden üblicherweise als Übergangselemente bezeichnet. Da diese Elemente alle Metalle sind, wird auch der Ausdruck Übergangsmetalle benutzt.

Gemäß einem weiteren Ausführungsbeispiel können die ersten Nanopartikel der ersten Nanopartikelstruktur und/oder die zweiten Nanopartikel der zweiten Nanopartikelstruktur eine oxidische Materialverbindung aus Sauerstoff und einem Übergangsmetall aufweisen. Eine solche Chalkogenid-Verbindung mit Sauerstoff ist im Vergleich zu Chalkogenid-Verbindungen mit Selen oder Tellur für manche Anwendungen vorteilhaft, da letztere Chalkogenid-Verbindungen giftig sind.

Gemäß einem weiteren Ausführungsbeispiel können die ersten Nanopartikel der ersten Nanopartikelstruktur und/oder die zweiten Nanopartikel der zweiten Nanopartikelstruktur zumindest eine oxidische Materialverbindung aus der Gruppe von ZnO, TiO₂, MoO₃, WO₃ und Fe₂O₃ aufweisen.

Gemäß einem weiteren Ausführungsbeispiel können die ersten Nanopartikel der ersten Nanopartikelstruktur und/oder die zweiten Nanopartikel der zweiten Nanopartikelstruktur eine sulfidische Materialverbindung aus Schwefel und einem Übergangsmetall aufweisen. Eine solche Chalkogenid-Verbindung mit Schwefel ist im Vergleich zu Chalkogenid-Verbindungen mit Selen oder Tellur für manche Anwendungen vorteilhaft, da letztere Chalkogenid-Verbindungen giftig sind.

Gemäß einem weiteren Ausführungsbeispiel können die ersten Nanopartikel der ersten Nanopartikelstruktur und/oder die zweiten Nanopartikel der zweiten Nanopartikelstruktur zumindest eine sulfidische Materialverbindung aus der Gruppe von MoS₂, WS₂ und FeS₂ (Eisendisulfid, Pyrith) aufweisen.

Gemäß einem weiteren Ausführungsbeispiel können die ersten Nanopartikel der ersten Nanopartikelstruktur ein Material aus der chemischen Hauptgruppe III aufweisen, und die zweiten Nanopartikel der zweiten Nanopartikelstruktur können ein Material aus der chemischen Hauptgruppe V aufweisen. Natürlich ist es ebenfalls möglich, dass die ersten Nanopartikel der ersten Nanopartikelstruktur ein Material aus der chemischen Hauptgruppe V aufweisen, und die zweiten Nanopartikel der zweiten Nanopartikelstruktur ein Material aus der chemischen Hauptgruppe III aufweisen.

Gemäß einem weiteren Ausführungsbeispiel können die ersten Nanopartikel der ersten Nanopartikelstruktur und die zweiten Nanopartikel der zweiten Nanopartikelstruktur jeweils das gleiche Material, jedoch mit einer unterschiedlichen Dotierung, aufweisen. Das heißt, das Halbleiter-Strukturelement weist einen homogenen Aufbau auf, wobei die ersten Nanopartikel der ersten Nanopartikelstruktur und die zweiten Nanopartikel der zweiten Nanopartikelstruktur die gleichen Materialien aufweisen können, wobei diese Materialien vorzugsweise die gleichen Halbleitermaterialien sind. Diese können beispielsweise eine unterschiedliche Dotierung aufweisen, sodass es an den Kontaktstellen zwischen den Nanopartikeln mit unterschiedlicher Dotierung zur Ausbildung von p-n-Übergängen kommt.

Gemäß einem weiteren Ausführungsbeispiel können die ersten Nanopartikel der ersten Nanopartikelstruktur und die zweiten Nanopartikel der zweiten Nanopartikelstruktur jeweils das gleiche Material aufweisen, welches ein Element der chemischen Hauptgruppe IV enthält. Hierzu zählen unter anderem Kohlenstoff (C), Silizium (Si) oder Germanium (Ge).

Gemäß einem weiteren Ausführungsbeispiel können die erste Nanopartikelstruktur und die zweite Nanopartikelstruktur jeweils als eine Nanopartikelschicht ausgeführt sein, wobei diese Nanopartikelschichten in einem Schichtstapel übereinander angeordnet sind. Dies bietet eine einfache Art und Weise, die einzelnen Nanopartikelstrukturen miteinander zu kontaktieren. Das Erstellen von Schichtstapeln mit Nanopartikel beinhaltenden Schichten kann außerdem aus konventionellen Verfahren zum Herstellen von konventionellen, nicht nanopartikelbasierten, Halbleiterstrukturen übernommen werden. Dies bietet eine kostengünstige Adaption bestehender Technik, angewendet auf ein anderes technisches Gebiet.

Gemäß einem weiteren Ausführungsbeispiel kann das Halbleiter-Strukturelement eine dritte Nanopartikelschicht mit einer Vielzahl von dritten Nanopartikeln aufweisen, wobei die zweite Nanopartikelschicht zwischen der ersten und der dritten Nanopartikelschicht angeordnet ist, und wobei sich an den jeweiligen Kontaktpunkten von zweiten und dritten Nanopartikeln ein zweiter p-n-Übergang mit einer vorbestimmten Raumladungszone ausbildet. Auch bei diesem zweiten p-n-Übergang gilt sinngemäß, dass dieser natürlich auch einen n-p-Übergang einschließt. Es wird also ein Schichtstapel bereitgestellt, der drei Nanopartikelstrukturen in Form von drei aufeinander gestapelten Nanopartikelschichten aufweist. Dabei kann es denkbar sein, dass die zweite und die dritte Nanopartikelstruktur einen homogenen oder einen heterogenen Aufbau aufweisen, wie dies zuvor mit Bezug auf die erste und zweite Nanopartikelstrukturen beschrieben wurde. Die erste und die dritte Nanopartikelstruktur können das gleiche Material oder unterschiedliche Materialien aufweisen, wobei das Material der dritten Nanopartikelstruktur vorzugsweise ein Halbleitermaterial ist.

Gemäß einem weiteren Ausführungsbeispiel kann zumindest eine der ersten, zweiten und dritten Nanopartikelschichten mittels entsprechender Strukturierung freigelegt sein, sodass sich in der Umgebung befindliche Moleküle an die jeweils freigelegte Nanopartikelschicht anlagern können. Freigelegt bedeutet in diesem Zusammenhang, dass die jeweilige Nanopartikelschicht eine Strukturierung, z.B. Loch, Graben, etc. aufweist, wobei diese Strukturierung laterale Seitenwände aufweist, die mit der Umgebung in Kontakt bringbar sind. Dies ermöglicht eine laterale Eindiffusion von in der Umgebung befindlichen Molekülen durch ebendiese lateralen Seitenwände. Das heißt, es wird eine mehrseitige Eindiffusion ermöglicht. Im Vergleich dazu ist ohne eine solche Strukturierung keine laterale Diffusion möglich, sondern lediglich eine Eindiffusion von einer Seite (z.B. einer unstrukturierten Oberseite).

Gemäß einem weiteren Ausführungsbeispiel kann das nanopartikelbasierte Halbleiter-Strukturelement eine Diodenstruktur mit einem p-n-Übergang, oder eine Transistorstruktur mit zwei p-n-Übergängen, oder eine Thyristorstruktur mit drei p-n-Übergängen bilden.

Gemäß einem weiteren Ausführungsbeispiel kann das nanopartikelbasierte Halbleiter-Strukturelement eine elektrochemische Sensorstruktur sein, wobei die erste Nanopartikelstruktur und die direkt daran angrenzende zweite Nanopartikelstruktur zusammen eine Sensorschicht bilden.

Ein weiteres Ausführungsbeispiel sieht eine Sensoranordnung mit einem zuvor beschriebenen nanopartikelbasierten Halbleiter-Strukturelement vor.

Einige Ausführungsbeispiele sind exemplarisch in der Zeichnung dargestellt und werden nachstehend erläutert. Es zeigen:
- Fig. 1: eine schematische Ansicht eines nanopartikelbasierten Halbleiter-Strukturelements mit zwei Nanopartikelstrukturen gemäß einem Ausführungsbeispiel,
- Figs. 2A, 2B: eine schematische Skizze zur Erläuterung eines nanopartikelbasierten p-n-Übergangs,
- Figs. 3A, 3B: eine weitere schematische Skizze zur Erläuterung eines weiteren nanopartikelbasierten p-n-Übergangs,
- Figs. 4A-4C: eine schematische Skizze zur Erläuterung unterschiedlicher elektronischer Charakteristiken, die mittels nanopartikelbasierter p-n-Übergange realisierbar sind,
- Fig. 5A: ein als Sensoranordnung ausgestaltetes Halbleiter-Strukturelement aufweisend einen Schichtstapel mit drei Nanopartikelstrukturen,
- Fig. 5B: eine schematische Ansicht eines nanopartikelbasierten Halbleiter-Strukturelements mit drei Nanopartikelstrukturen gemäß einem Ausführungsbeispiel,
- Figs. 6A-6D: schematische Draufsichten und Schnittansichten von unterschiedlich strukturierten Halbleiter-Strukturelementen gemäß verschiedenen Ausführungsbeispielen, und
- Fig. 7: ein schematisches Blockdiagramm zur Kategorisierung unterschiedlicher nanopartikelbasierter Halbleiter-Strukturelemente.

Im Folgenden werden Ausführungsbeispiele mit Bezug auf die Figuren näher beschrieben, wobei Elemente mit derselben oder ähnlichen Funktion mit denselben Bezugszeichen versehen sind.

Außerdem wird hierin eine Sensoranordnung, und in einigen expliziten Beispielen ein elektrochemischer Sensor, als ein nicht-limitierendes Beispiel für ein erfindungsgemäßes Halbleiter-Strukturelement beschrieben. Selbstverständlich ist das erfindungsgemäße Halbleiter-Strukturelement nicht auf eine solche, lediglich beispielhaft genannte, Sensorik beschränkt.

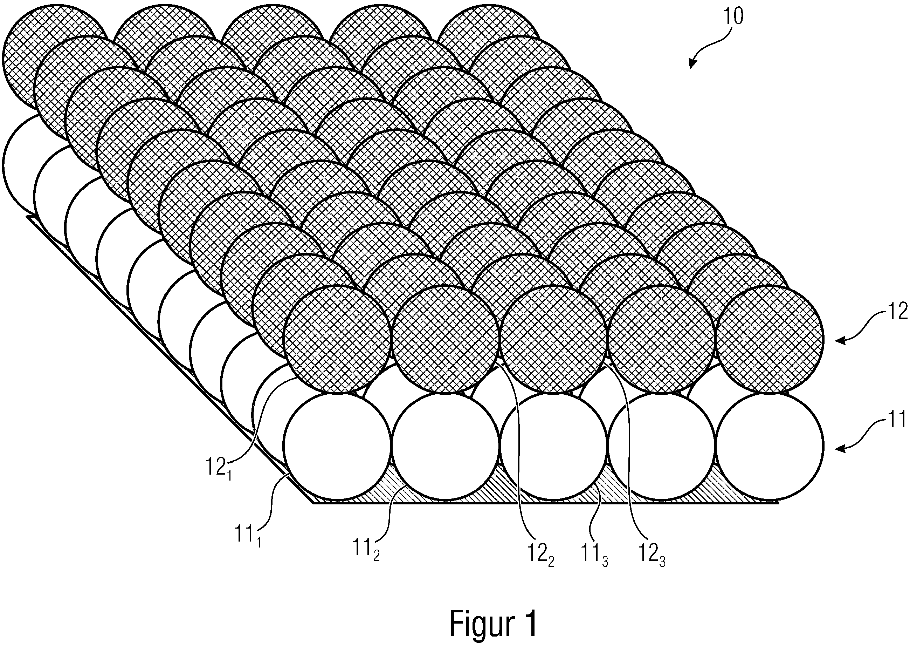

Figur 1 zeigt ein erfindungsgemäßes nanopartikelbasiertes Halbleiter-Strukturelement 10. Das nanopartikelbasierte Halbleiter-Strukturelement 10 weist eine erste Nanopartikelstruktur 11 mit einer Vielzahl von ersten Nanopartikeln 11₁, 11₂, 11₃ auf. Das nanopartikelbasiertes Halbleiter-Strukturelement 10 weist außerdem eine zweite Nanopartikelstruktur 12 mit einer Vielzahl von zweiten Nanopartikeln 12₁, 12₂, 12₃ auf.

Die erste Nanopartikelstruktur 11 und die zweite Nanopartikelstruktur 12 sind in diesem nicht-limitierenden Ausführungsbeispiel als einlagige zweidimensionale Strukturen ausgeführt, die in etwa vergleichbar sind mit einlagigen Schichten. Die Nanopartikelstrukturen 11, 12 sind jedoch nicht auf zweidimensionale geometrische Formen beschränkt. Die Nanopartikelstrukturen 11, 12 können auch eindimensionale sowie dreidimensionale geometrische Formen aufweisen, beispielsweise in Form von Würfeln, Quadern, Nanotubes und dergleichen. Außerdem können die Nanopartikelstrukturen 11, 12 unterschiedliche geometrische Formen, oder aber jeweils die gleiche geometrische Form, wie in Figur 1 abgebildet, aufweisen.

Die erste Nanopartikelstruktur 11 und die zweite Nanopartikelstruktur 12 sind direkt aneinander angrenzend angeordnet, sodass zumindest ein Teil der ersten Nanopartikel 11₁, 11₂, 11₃ und zumindest ein Teil der zweiten Nanopartikel 12₁, 12₂, 12₃ in direktem Kontakt miteinander sind.

Dabei bilden sich an den jeweiligen Kontaktpunkten von ersten und zweiten Nanopartikeln 11₁, 11₂, 11₃, 12₁, 12₂, 12₃ ein p-n-Übergang mit einer vorbestimmten Raumladungszone aus. Genauer gesagt kann sich an jedem Kontaktpunkt, an dem ein erstes Nanopartikel 11₁, 11₂, 11₃ ein zweites Nanopartikel 12₁, 12₂, 12₃ physisch kontaktiert, jeweils ein p-n-Übergang ausbilden.

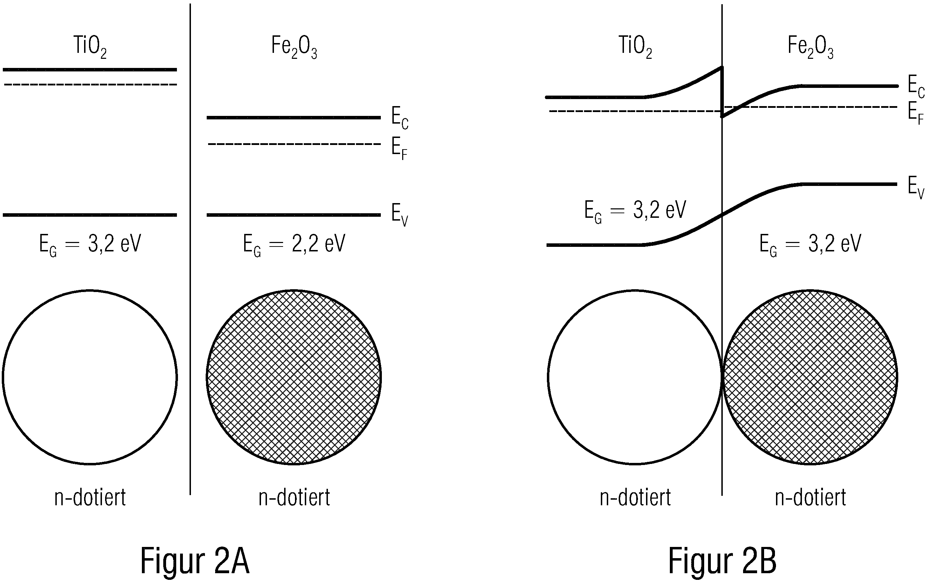

Dies soll beispielhaft unter Bezugnahme auf die Figuren 2A und 2B näher erläutert werden. Es sind ein n-dotiertes TiO₂ Nanopartikel sowie ein n-dotiertes Fe₂O₃ Nanopartikel zu sehen, wobei die Nanopartikel in Figur 2A voneinander getrennt sind, und wobei sich die Nanopartikel in Figur 2B gegenseitig berühren. Jeweils darüber sind deren Energiebänder eingezeichnet d.h. das Valenzband Eᵥ, das darüberliegende Leitungsband E_{C} und das dazwischen angeordnete Ferminiveau E_{F}.

Wie in Figur 2A zu erkennen ist, besitzt das TiO₂ Nanopartikel ein im Vergleich zum Fe₂O₃ Nanopartikel höheres Leitungsband E_{C}, wodurch sich beim TiO₂ Nanopartikel eine im Vergleich zum Fe₂O₃ Nanopartikel größere Bandlücke E_{G} ergibt. Außerdem liegt das Ferminiveau E_{F} beim TiO₂ Nanopartikel höher als beim Fe₂O₃ Nanopartikel.

Wie in Figur 2B zu sehen ist, kommt es beim Kontakt der beiden Nanopartikel zum Driften bzw. zur Diffusion von Ladungsträgern, wodurch sich die Ferminiveaus E_{F} beider Nanopartikel angleichen. Dies führt zu einem p-n-Übergang mit einer vorbestimmten Raumladungszone. Im Bereich der Leitungsbänder Ec kommt es zu einem sprunghaften Übergang. Im Wesentlichen ergibt sich demnach, aufgrund der unterschiedlichen Energieniveaus der jeweiligen Energiebänder, beim gegenseitigen Kontakt der beiden Nanopartikel eine Diodencharakteristik. Der in Figur 2B dargestellte Sprung im Leitungsband Ec kann bei geeigneter Polung zu einem Tunneleffekt führen, der die ohnehin nicht-lineare Diodencharakteristik nochmals deutlich verstärken kann.

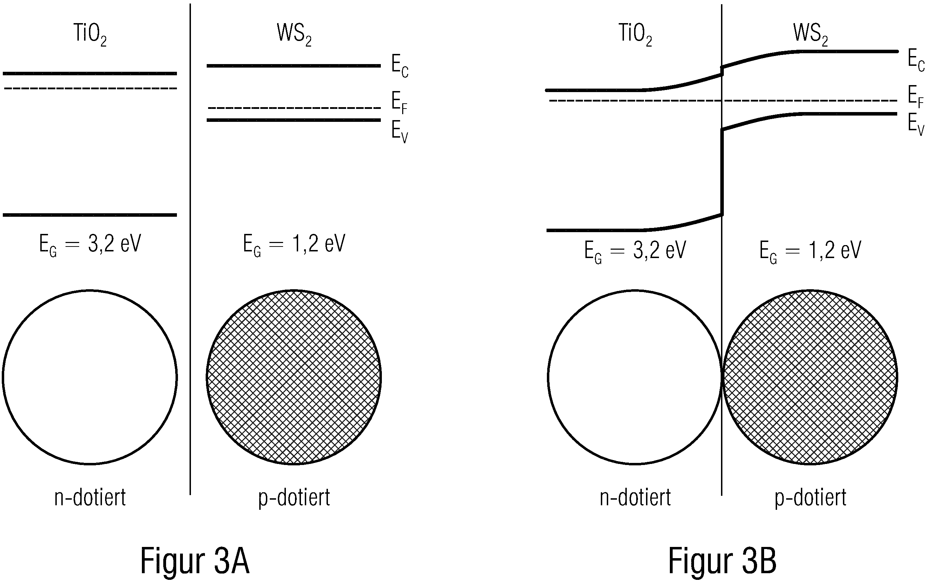

In den Figuren 3A und 3B ist ein weiteres derartiges Beispiel abgebildet, wobei sich ein n-dotiertes TiO₂ Nanopartikel und ein p-dotiertes WS₂ Nanopartikel gegenseitig kontaktieren. Auch hier gleichen sich durch Diffusion bzw. Drift der Ladungsträger die Ferminiveaus E_{F} der jeweiligen Nanopartikel aneinander an. Bei diesem Beispiel kommt es ebenfalls zu einem sprunghaften Übergang, jedoch diesmal im Bereich der Valenzbänder E_{V}.

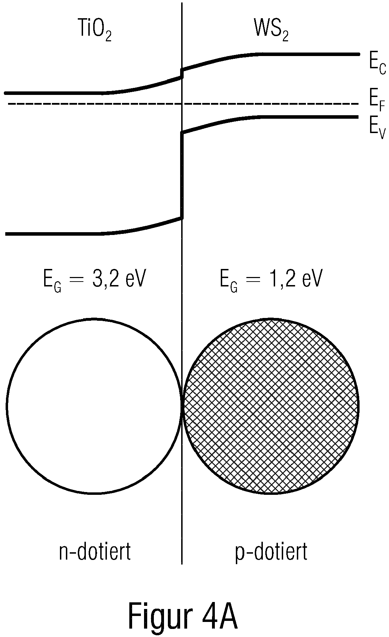

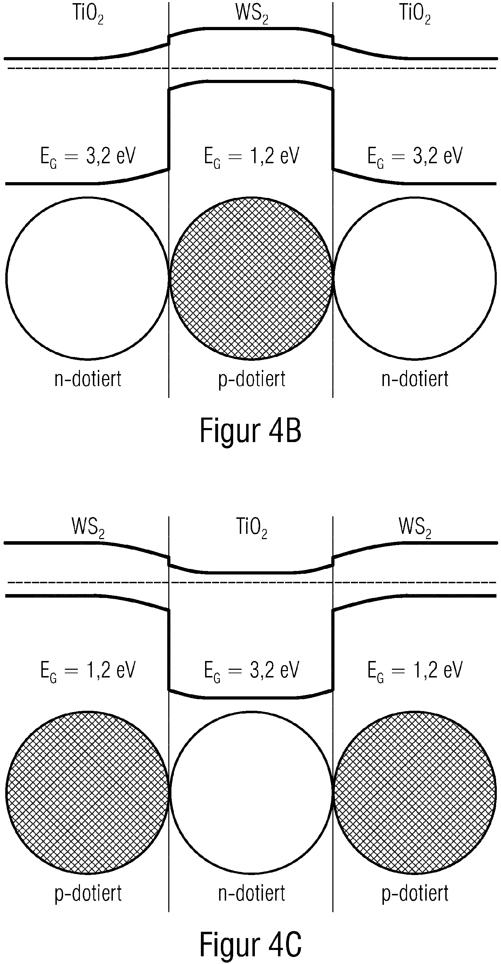

Die Figuren 4A, 4B und 4C zeigen rein beispielhaft, welche Bauteilcharakteristiken mit dem erfindungsgemäßen Halbleiter-Strukturelement 10 auf diese Art realisierbar sind. Figur 4A zeigt einen soeben beschriebenen p-n-Übergang zwischen einem TiO₂ und einem WS₂ Nanopartikel, was zu einer Diodencharakteristik führt. Figur 4B zeigt zwei p-n-Übergänge an den jeweiligen Kontaktpunkten von zwei TiO₂ Nanopartikeln zu einem dazwischen angeordneten WS₂ Nanopartikel. Dies führt zu einer Transistorcharakteristik eines n-p-n-Transistors. Figur 4B zeigt zwei p-n-Übergänge an den jeweiligen Kontaktpunkten von zwei WS₂ Nanopartikeln zu einem dazwischen angeordneten TiO₂ Nanopartikel. Dies führt zu einer Transistorcharakteristik eines p-n-p-Transistors.

In allen Beispielen kommt es beim Kontakt der jeweiligen Nanopartikel zur Einstellung eines Energie-Gleichgewichts, sodass sich eine vorbestimmte Raumladungszone ausbildet. Diese vorbestimmte Raumladungszone führt dazu, dass das erfindungsgemäße Halbleiter-Strukturelement 10 einen vorbestimmten Leitwert aufweist.

Durch Anlagerung von beispielsweise in der Umgebung befindlichen Molekülen an den jeweiligen Nanopartikelstrukturen 11, 12 verschiebt sich die vorbestimmte Raumladungszone und damit der vorbestimmte Leitwert des Halbleiter-Strukturelements 10.

Bedingt durch den Aufbau der Nanopartikelstrukturen 11, 12 weisen diese eine diffusionsoffene äußere sowie innere Struktur auf, sodass die zuvor genannten Moleküle aus der Umgebung in die jeweilige Nanopartikelstruktur 11, 12 eindiffundieren können.

Dabei ist das nanopartikelbasierte Halbleiter-Strukturelement 10 derart ausgestaltet, dass sich die vorbestimmte Raumladungszone und somit der vorbestimmte Leitwert des nanopartikelbasierten Halbleiter-Strukturelements 10 verändert, wenn sich eindiffundierte Moleküle an der Oberfläche von in der jeweiligen Nanopartikelstruktur 11, 12 enthaltenen Nanopartikeln 11₁, 112, 113, 12₁, 12₂, 123 anlagern.

Dies kann vorteilhaft für beispielsweise elektrochemische Sensorik-Anwendungen genutzt werden, um beispielsweise einen bestimmten Analyten zu bestimmen. Je nachdem, welche Stoff-Moleküle sich an den jeweiligen Nanopartikeln 11₁, 11₂, 11₃, 12₁, 12₂, 12₃ anlagern, verändert sich die vorbestimmte Raumladungszone und somit der vorbestimmte Leitwert des Halbleiter-Strukturelements 10 in unterschiedlichem Maße. Dies wiederum ist ein charakteristisches Indiz für den jeweiligen Stoff des angelagerten Moleküls, sodass dieser Stoff als Analyt bestimmt werden kann. Dies kann mit einer entsprechenden Auswertevorrichtung durchführbar sein.

Dementsprechend sehen Ausführungsbeispiele vor, dass das nanopartikelbasierte Halbleiter-Strukturelement 10 eine Auswertevorrichtung aufweisen kann, oder zumindest an eine solche Auswertevorrichtung anschließbar ist, wobei die erste und/oder die zweite Nanopartikelstruktur 11, 12 (gemeinsam oder jeweils einzeln) eine elektrochemische Sensorstruktur bereitstellen, wobei Moleküle eines Analyten in diese elektrochemische Sensorstruktur eindiffundieren und sich an der Oberfläche von darin befindlichen Nanopartikeln 11₁, 11₂, 11₃, 12₁, 12₂, 12₃ anlagern können, um die vorbestimmte Raumladungszone und somit den vorbestimmten Leitwert des nanopartikelbasierten Halbleiter-Strukturelements 10 zu verändern. Die Auswertevorrichtung kann dementsprechend dazu ausgestaltet sein, um basierend auf der Änderung des Leitwerts den Analyten zu bestimmen.

Basierend auf dem jeweiligen Analyten wird ein dementsprechendes Signal von dem Halbleiter-Strukturelement 10 erzeugt. Ein Vorteil des erfindungsgemäßen nanopartikelbasierten Halbleiter-Strukturelements 10 besteht dabei darin, dass dieses derart ausgestaltet sein kann, um ein Signal mit intrinsisch nicht-linearer Verstärkung zu erzeugen.

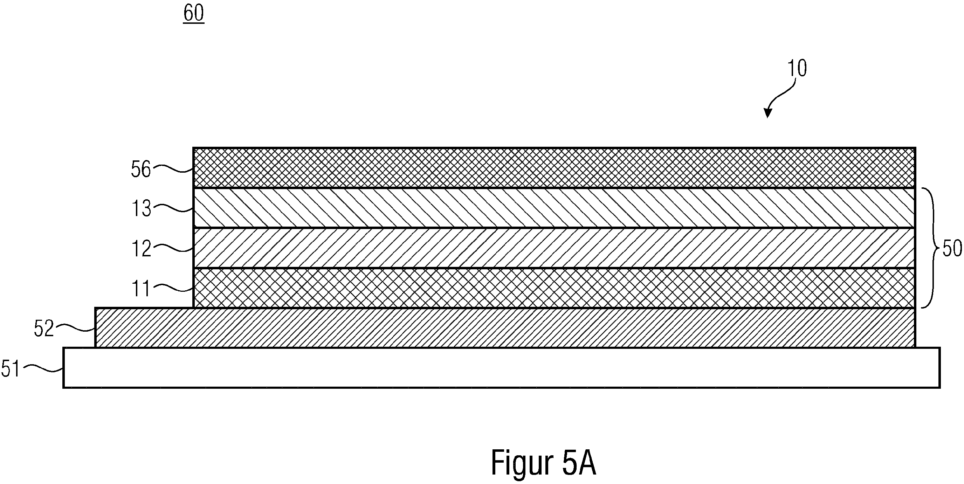

Figur 5A zeigt ein Ausführungsbeispiel eines erfindungsgemäßen Halbleiter-Strukturelements 10, das beispielsweise als eine elektrochemische Sensoranordnung 60 verwendet werden kann. Das Halbleiter-Strukturelement 10 weist einen Schichtstapel 50 auf, der eine erste, eine zweite und eine dritte Nanopartikelschicht 11, 12, 13 aufweist.

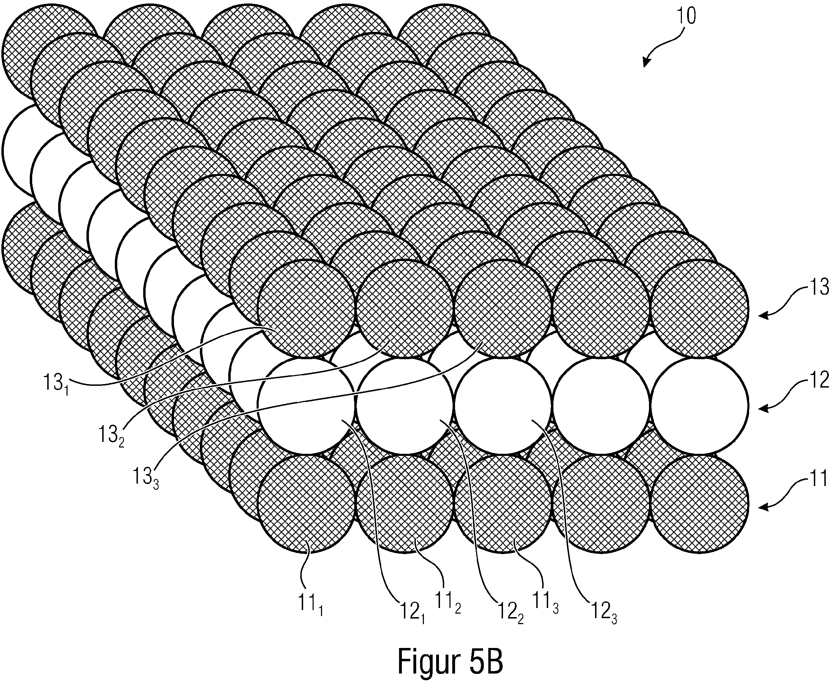

Dies ist etwas genauer in Figur 5B dargestellt. Das Halbleiter-Strukturelement 10 weist eine erste Nanopartikelstruktur 11 mit einer Vielzahl von ersten Nanopartikeln (11₁, 11₂, 11₃), eine zweite Nanopartikelstruktur 12 mit einer Vielzahl von zweiten Nanopartikeln (12₁, 12₂, 12₃) und eine dritte Nanopartikelstruktur 13 mit einer Vielzahl von dritten Nanopartikeln (13₁, 13₂, 13₃) auf. Dabei ist die zweite Nanopartikelstruktur 12 zwischen der ersten und der zweiten Nanopartikelstruktur 11, 13 angeordnet. Die jeweiligen Nanopartikelstrukturen 11, 12, 13 sind hier rein beispielhaft als Schichten mit mehreren Nanopartikeln dargestellt, die gemeinsam einen Nanopartikelschichtstapel 50 bilden. Eine Ausführung als Schichtstapel ist natürlich auch mit zwei oder mehr als den abgebildeten drei Nanopartikelschichten denkbar. Wie zuvor beschrieben, kann sich hierbei zwischen den einzelnen Nanopartikeln der jeweiligen Nanopartikelstrukturen (bzw. Nanopartikelschichten) 11, 12, 13 jeweils ein p-n-Übergang ausbilden.

Das in Figur 5A abgebildete Halbleiter-Strukturelement 10 kann optional weitere Elemente bzw. Schichten aufweisen. Beispielsweise kann ein Substrat 51 vorgesehen sein, auf welchem der zuvor erwähnte Nanopartikelstruktur-Schichtstapel 50 angeordnet sein kann. Das Substrat 51 kann beispielsweise ein transparentes Substrat sein und beispielsweise einen oder mehrere Bestandteile aus der Gruppe von Glas, Quarz, Polymer oder Silizium aufweisen.

Ferner optional kann zwischen dem Substrat 51 und dem Schichtstapel 50 eine elektrisch leitfähige Beschichtung 52 vorgesehen sein. Diese kann beispielsweise zur Ankontaktierung des Halbleiter-Strukturelements 10 dienen. Die elektrisch leitfähige Beschichtung 52 kann beispielsweise einen oder mehrere Bestandteile aus der Gruppe von Indium-Zinnoxid (ITO), Fluor-dotiertem-Zinnoxid (FTO) und Metall aufweisen. Außerdem kann die elektrisch leitfähige Beschichtung 52 ebenfalls transparent sein.

Ferner optional kann eine weitere elektrisch leitfähige Beschichtung 56 vorgesehen sein. Diese kann beispielsweise auf der dem Substrat 51 gegenüberliegenden Seite des Schichtstapels 50 angeordnet sein und zur Ankontaktierung des Halbleiter-Strukturelements 10 dienen. Die weitere elektrisch leitfähige Beschichtung 56 kann beispielsweise einen oder mehrere Bestandteile aus der Gruppe von Indium-Zinnoxid (ITO), Fluor-dotiertem-Zinnoxid (FTO) und Metall aufweisen. Außerdem kann die weitere elektrisch leitfähige Beschichtung 52 ebenfalls transparent sein.

Der Schichtstapel 50 selbst kann in diesem Falle, wie zuvor beschrieben, eine Transistorcharakteristik aufweisen. Dabei kann die in der Mitte liegende zweite Nanopartikelschicht 12 als elektrische Basis dienen. Die erste Nanopartikelschicht 11 und die dritte Nanopartikelschicht 13 können jeweils entweder als elektrische Source oder Drain (bzw. anders herum) dienen.

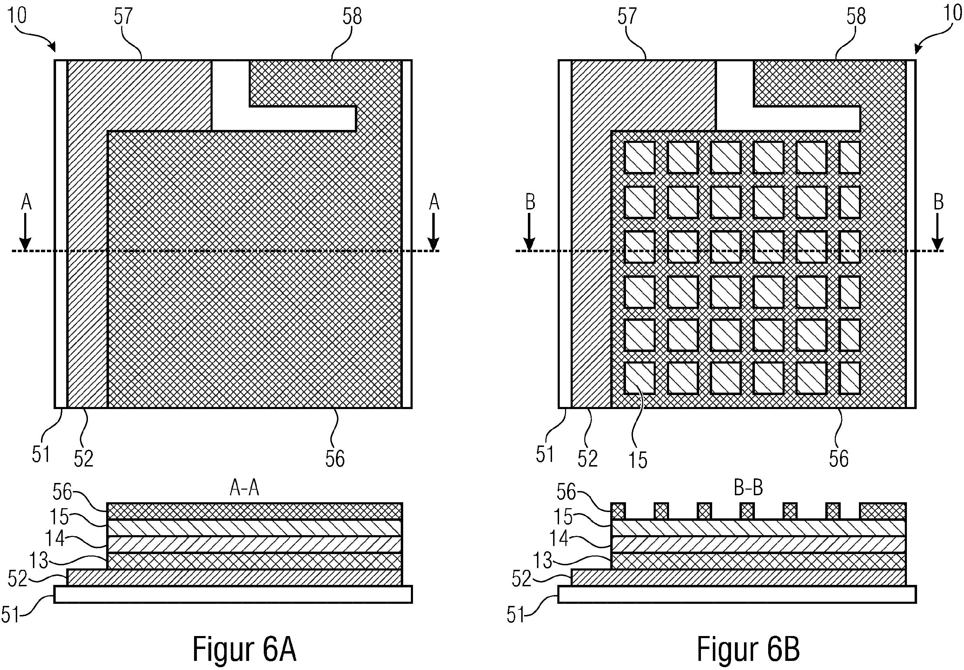

Figur 6A zeigt eine Draufsicht auf das Halbleiter-Strukturelement 10 aus Figur 5A. Hier sind die elektrisch leitfähigen Schichten 52, 56 zu sehen, die jeweils eine Kontaktfläche 57, 58 zur elektrischen Ankontaktierung des Halbleiter-Strukturelements 10, und insbesondere der elektrischen Drain bzw. Source, bereitstellen.

Sofern die weitere, bzw. obere, elektrisch leitfähige Beschichtung 56 porös ist, so können in der Umgebung befindliche Moleküle durch diese poröse Beschichtung 56 hindurch diffundieren und an die darunter liegende dritte Nanopartikelstruktur 13 gelangen, um sich dort an der Oberfläche der darin enthaltenen Nanopartikel anzulagern. Hierfür kann die weitere elektrisch leitfähige Beschichtung 56 beispielsweise ebenfalls als eine poröse Nanopartikelstruktur ausgeführt sein. Denkbar wären Ausgestaltungen beinhaltend Metall-Nanopartikel, ITO-Nanopartikel oder FTO-Nanopartikel.

Falls die weitere, bzw. obere, elektrisch leitfähige Beschichtung 56 nicht porös sein sollte, so können in der Umgebung befindliche Moleküle nicht bzw. nur erschwert durch diese poröse Beschichtung 56 hindurch diffundieren. Aus diesem Grund sehen Ausführungsbeispiele vor, das Halbleiter-Strukturelement 10 entsprechend zu strukturieren. Dies kann beispielsweise mittels in der Halbleitertechnik etablierter Prozesse, wie beispielsweise Lithografie, erfolgen. Einige nicht-limitierende Ausführungsbeispiele solcher strukturierter Halbleiter-Strukturelemente 10 sollen nachfolgend unter Bezugnahme auf die Figuren 6B bis 6D näher beschrieben werden.

Die Figuren 6A bis 6D zeigen allesamt Draufsichten auf ein Halbleiter-Strukturelement 10 wie es zuvor unter Bezugnahme auf Figur 5A beispielhaft beschrieben wurde, sowie Schnittansichten entlang der jeweiligen Schnittlinien A-A, B-B, C-C, D-D.

In dem in Figur 6B gezeigten Ausführungsbeispiel ist die weitere, bzw. obere, elektrisch leitfähige Schicht 56 strukturiert worden. Hier wurden beispielhaft viereckige Aussparungen in die elektrisch leitfähige Schicht 56 strukturiert. Diese Aussparungen ermöglichen es, dass in der Umgebung befindliche Moleküle zu der dritten Nanopartikelstruktur 13 gelangen können, um sich dort an der Oberfläche der jeweiligen Nanopartikel anzulagern.

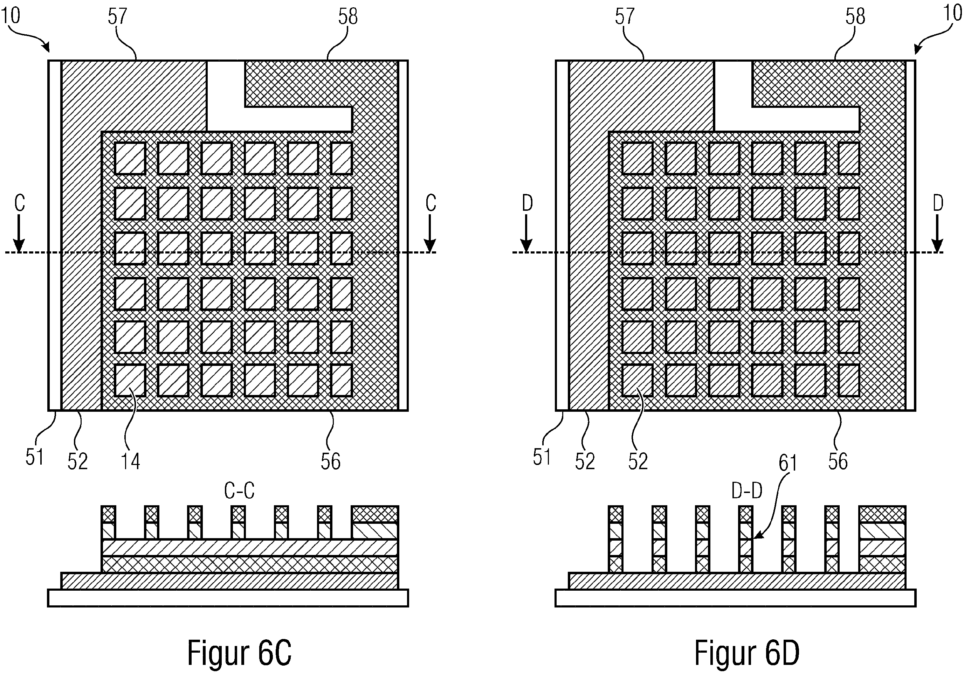

In dem in Figur 6C gezeigten Ausführungsbeispiel ist alternativ oder zusätzlich zu der weiteren, bzw. oberen, elektrisch leitfähigen Schicht 56 auch die darunterliegende dritte Nanopartikelstruktur 13 strukturiert worden. Hier wurden ebenfalls rein beispielhaft viereckige Aussparungen in die elektrisch leitfähige Schicht 56 sowie in die dritte Nanopartikelstruktur 13 strukturiert. Diese Aussparungen ermöglichen es, dass in der Umgebung befindliche Moleküle zu der dritten Nanopartikelstruktur 13 und auch zu der darunter liegenden zweiten Nanopartikelstruktur 12 gelangen können, um sich dort an der Oberfläche der jeweiligen Nanopartikel anzulagern.

In dem in Figur 6D gezeigten Ausführungsbeispiel ist alternativ oder zusätzlich zu dem in Figur 6C gezeigten Ausführungsbeispiel auch die zweite Nanopartikelstruktur 12 strukturiert worden. Hier wurden ebenfalls rein beispielhaft viereckige Aussparungen in die elektrisch leitfähige Schicht 56 sowie in die zweite und dritte Nanopartikelstrukturen 12, 13 strukturiert. Diese Aussparungen ermöglichen es, dass in der Umgebung befindliche Moleküle zu der dritten Nanopartikelstruktur 13, zu der darunter liegenden zweiten Nanopartikelstruktur 12 und auch zu der ihrerseits darunterliegenden ersten Nanopartikelstruktur 11 gelangen können, um sich dort an der Oberfläche der jeweiligen Nanopartikel anzulagern. Ein Vorteil bei den in den Figuren 6C und 6D gezeigten Ausführungsbeispielen liegt darin, dass die Moleküle auch entlang von lateralen Seitenwänden 61 in die jeweilige Nanopartikelstruktur 11, 12, 13 eindiffundieren können. Diese lateralen Seitenwände ergeben sich aus dem Prozess der Strukturierung und erstrecken sich sozusagen in einer Richtung senkrecht zur Substratebene, d.h. ausgehend vom Substrat 51 vertikal nach oben bzw. vom Substrat 51 weg.

Die soeben beschriebenen Ausführungsbeispiele sehen also allesamt vor, dass zumindest eine der ersten, zweiten und dritten Nanopartikelschichten 11, 12, 13 mittels entsprechender Strukturierung freigelegt ist, sodass sich in der Umgebung befindliche Moleküle an die jeweils freigelegte Nanopartikelschicht 11, 12, 13 anlagern können. Dies gilt natürlich nicht nur für Nanopartikelschichten, sondern generell auch für jegliche Nanopartikelstrukturen im Sinne der vorliegenden Offenbarung, d.h. unabhängig von deren geometrischen Form und Ausgestaltung.

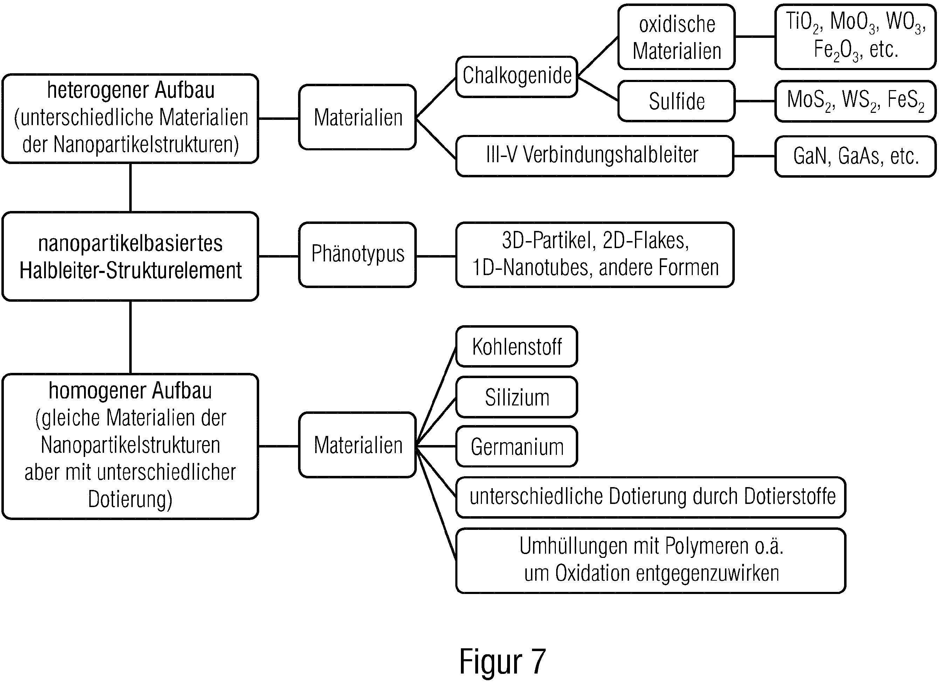

Ein wichtiges Kriterium zur Realisierung des hierin beschriebenen Halbleiter-Strukturelements 10 ist die Materialwahl, insbesondere für die Nanopartikelstrukturen 11, 12, 13. Nachfolgend sollen daher unterschiedliche Materialkompositionen beschrieben werden, wobei diese als nicht abschließende Beispiele zu verstehen sind. Figur 7 zeigt eine Übersicht von verwendbaren Materialien und Materialkompositionen.

Zunächst kann das nanopartikelbasierte Halbleiter-Strukturelement 10 unterschiedliche Nanopartikelstrukturen 11, 12, 13 aufweisen, die entsprechend ihrem jeweiligen Phänotypus untergliedert werden können. Wie eingangs erwähnt, sind eindimensionale, zweidimensionale oder auch dreidimensionale Ausgestaltungen der jeweiligen Nanopartikelstrukturen 11, 12, 13 denkbar. So können beispielsweise 3D-Partikel, 2D-Flakes, 1D-Nanotubes, aber auch andere Formen möglich sein.

Es ist zum Beispiel denkbar, dass kugelige Nanopartikel mit einer Beschichtung überzogen werden, sodass sich zwischen dem Nanopartikel und der Beschichtung ein p-n-Übergang ausbildet. Dies wäre beispielsweise realisierbar, indem man WS₂-Flakes oxidiert, sodass WO₃ entsteht. Das WO₃ könnte dann wiederum als Beschichtung von kugeligen TiO₂ Nanopartikeln verwendet werden. Dabei würden beispielsweise eine Vielzahl von kugeligen TiO₂ Nanopartikel eine erste Nanopartikelstruktur bilden, und die WO₃-Beschichtung würde eine zweite Nanopartikelstruktur bilden, wobei sich an den Kontaktpunkten jeweils ein p-n-Übergang ausbildet.

Wie in Figur 7 zu sehen ist, können die hierin beschriebenen Halbleiter-Strukturelemente 10 des weiteren bezüglich des Aufbaus der jeweiligen Nanopartikelstrukturen 11, 12, 13 unterschieden werden. Dabei kann unterschieden werden zwischen einem homogenen Aufbau und einem heterogenen Aufbau der Nanopartikelstrukturen. Bei einem homogenen Aufbau weisen die mindestens zwei Nanopartikelstrukturen 11, 12 gleiche Materialien, aber mit unterschiedlicher Dotierung auf. Beim heterogenen Aufbau hingegen weisen die mindestens zwei Nanopartikelstrukturen 11, 12 unterschiedliche Materialien auf, die sich in der Höhe der Austrittsarbeiten für Elektronen und/oder in der Höhe der jeweiligen Bandlücke voneinander unterscheiden

Zunächst soll der heterogene Aufbau diskutiert werden. Gemäß Ausführungsbeispielen können die ersten Nanopartikel 11₁, 11₂, 11₃ der ersten Nanopartikelstruktur 11 und die zweiten Nanopartikel 12₁, 122, 123 der zweiten Nanopartikelstruktur 12 jeweils unterschiedliche Materialien aus der chemischen Hauptgruppe VI, die auch als Chalkogene bezeichnet werden, aufweisen. Hierzu zählen Sauerstoff (O), Schwefel (S), Selen (Se), Tellur (Te), sowie Polonium (Po) und Livermorium (Lv). Beispielsweise könnte also die erste Nanopartikelstruktur 11 eine Vielzahl von Nanopartikeln 11₁, 11₂, 11₃ aufweisen, die mindestens ein erstes Chalkogen-Element aufweisen. Die zweite Nanopartikelstruktur 12 könnte eine Vielzahl von Nanopartikeln 12₁, 12₂, 12₃ aufweisen, die mindestens ein zweites, von dem ersten Chalkogen-Element unterschiedliches, Chalkogen-Element aufweisen.

Chalkogene können Verbindungen mit weiteren Elementen eingehen. Diese Verbindungen werden auch als Chalkogenide bezeichnet. Beispielsweise können Übergangsmetalle an Chalkogen-Elemente gebunden werden. Diese Chalkogenide weisen Halbleitereigenschaften auf.

Gemäß einem solchen Ausführungsbeispiel können also beispielsweise die ersten Nanopartikel 11₁, 11₂, 11₃ der ersten Nanopartikelstruktur 11 und die zweiten Nanopartikel 12₁, 12₂, 12₃ der zweiten Nanopartikelstruktur 12 jeweils unterschiedliche Materialverbindungen mit jeweils mindestens einem Element der chemischen Hauptgruppe VI und mindestens einem Übergangsmetall aufweisen.

Chalkogenide wiederum können unterteilt werden in Oxide, Sulfide, Selenide und Telluride und bilden je nach Bindungspartner gasförmige (wie zum Beispiel Kohlenstoffdioxid) oder meist feste Stoffe.

Gemäß einem solchen Ausführungsbeispiel könnten beispielsweise die ersten Nanopartikel 11₁, 11₂, 11₃ der ersten Nanopartikelstruktur 11 und die zweiten Nanopartikel 12₁, 12₂, 12₃ der zweiten Nanopartikelstruktur 12 jeweils unterschiedliche Materialverbindungen mit jeweils einer oxidischen Materialverbindung aus Sauerstoff und einem Übergangsmetall aufweisen. Der eingangs erwähnte heterogene Aufbau sieht dabei vor, dass die erste und die zweite Nanopartikelstruktur 11, 12 jeweils unterschiedliche oxidische Chalkogenide aufweisen kann. Beispielsweise könnten die erste und die zweite Nanopartikelstruktur 11, 12 jeweils unterschiedliche oxidische Chalkogenide aus der Gruppe von ZnO, TiO₂, MoO₃, WO₃ und Fe₂O₃ aufweisen.

Alternativ zu den oxidischen Chalkogeniden könnten sulfidische Chalkogenide vorgesehen sein. Gemäß einem derartigen Ausführungsbeispiel könnten beispielsweise die ersten Nanopartikel 11₁, 11₂, 11₃ der ersten Nanopartikelstruktur 11 und/oder die zweiten Nanopartikel 12₁, 12₂, 12₃ der zweiten Nanopartikelstruktur 12 eine sulfidische Materialverbindung aus Schwefel und einem Übergangsmetall aufweisen.

Sowohl sulfidische Chalkogenid-Verbindungen mit Schwefel als auch oxidische Chalkogenid-Verbindungen mit Sauerstoff sind im Vergleich zu Chalkogenid-Verbindungen mit Selen oder Tellur für manche Anwendungen vorteilhaft, da letztere Chalkogenid-Verbindungen giftig sind.

Alternativ zu den beschriebenen Chalkogeniden können die erste und zweite Nanopartikelstruktur 11, 12 als ein III-V Verbindungshalbleiter ausgestaltet sein. Gemäß einem derartigen Ausführungsbeispiel könnten beispielsweise die ersten Nanopartikel 11₁, 112, 113 der ersten Nanopartikelstruktur 11 ein Material aus der chemischen Hauptgruppe III aufweisen, und die zweiten Nanopartikel 12₁, 12₂, 12₃ der zweiten Nanopartikelstruktur 12 könnten ein Material aus der chemischen Hauptgruppe V aufweisen, oder anders herum. Auch dies entspräche einem heterogenen Aufbau.

Davon zu unterscheiden ist der homogene Aufbau der Nanopartikelstrukturen 11, 12. Hierbei weisen die ersten Nanopartikel 11₁, 11₂, 113 der ersten Nanopartikelstruktur 11 und die zweiten Nanopartikel 12₁, 12₂, 12₃ der zweiten Nanopartikelstruktur 12 jeweils das gleiche Material, jedoch mit einer unterschiedlichen Dotierung, auf. Dies ist im unteren Zweig von Figur 7 gezeigt.

Beispielsweise können die ersten Nanopartikel 11₁, 11₂, 11₃ der ersten Nanopartikelstruktur 11 und die zweiten Nanopartikel 12₁, 12₂, 12₃ der zweiten Nanopartikelstruktur 12 jeweils das gleiche Material aufweisen, welches ein Element der chemischen Hauptgruppe IV enthält. Hierzu zählen unter anderem Kohlenstoff (C), Silizium (Si) oder Germanium (Ge). Prinzipiell können hierbei unterschiedliche Dotierungen durch Dotierstoffe vorgesehen sein. Darüber hinaus wäre es denkbar, die Nanopartikelstrukturen 11, 12 zusätzlich mit Umhüllungen, beispielsweise aus Polymeren, zu versehen, um diese vor äußeren Einflüssen (z.B. Oxidation) zu schützen.

Nachfolgend soll das erfindungsgemäße Halbleiter-Strukturelement 10 nochmals in anderen Worten beschrieben und das erfinderische Konzept nochmals zusammengefasst werden:
Es sollen Nanopartikelstrukturen realisiert werden, die sich durch die Generierung von intrinsisch nichtlinear verstärkten elektrischen Signalen auszeichnen, sobald entsprechenden Moleküle an der Oberfläche der Nanopartikel (NP) angelagert sind. Die nichtlineare Verstärkung soll es ermöglichen auch bei sehr geringer Konzentration der Moleküle ein Signal zu erzielen, wobei keine Proportionalität zur Konzentration vorliegen muss. Idealerweise soll bei Erreichen eines (sehr niedrigen) Schwellenwertes eine Signalkaskade starten und in einen definierten maximalen Signalpeak enden. Dies wäre vorteilhaft verwendbar in der Sensorik. Mit dieser Charakteristik würden die Strukturen aber auch das Verhalten von biologischen Nervenzellen nachbilden können.

Die Erfindung bezieht sich unter anderem auf den Aufbau von dreidimensionalen Nanopartikelstrukturen, beispielsweise unter Verwendung von Nanopartikeln gemäß der in Figur 7 abgebildeten Übersicht. Demnach kann beispielsweise unterschieden werden in:
**a) Heterogene Elemente:** unterschiedliche Halbleitermaterialien z.B. aus der Verbindungsgruppe Chalcogenide (inklusive der oxidischen Verbindungen) oder z.B. der III-V-Verbindungshalbleiter. Die halbleitenden Materialien unterscheiden sich in der Höhe der Austrittsarbeiten für Elektronen und der Höhe der Bandlücken. Ohne Beeinflussung der grundlegenden Material-Dotierung erhält man im Kontaktbereich der Nanopartikel elektronische Übergänge mit pn- oder np-Charakteristik. Dies ist die Basis für elektronische Bauelemente wie z.B. Dioden und Transistoren.
   oder
**b) Homogene Elemente:** Gleiche Halbleiter-Elemente aber unterschiedliche Dotierung z.B. Silizium oder Germanium. Im Kontaktbereich der Nanopartikel erhält man elektronische Übergänge mit pn- oder np-Charakteristik. Dies ist die Basis für elektronische Bauelement wie z.B. Dioden und Transistoren.

Durch den Aufbau mit Nanopartikeln erhält man diffusionsoffene Schichten, in die Moleküle eindiffundieren können.

Eine Form der Realisierung sind horizontal geschichtete Nanopartikel mit pn-Übergängen im Kontaktbereich der unterschiedlichen Materialien (Figur 5A). Mit zwei Schichten erreicht man eine Dioden-Charakteristik. Es können aber auch mehr als zwei Lagen geschichtet sein. Bei dreifach-Schichtung ist damit ein Transistoraufbau möglich (npn, pnp). Eine Vierfach-Schichtung liefert prinzipiell den Aufbau von Thyristoren.

Chalcogenide sind die Verbindungen von Übergangsmetallen mit Elementen der Gruppe VI (O, S, Se, Te). Verbindungen, welche für diese Erfindung ins Auge gefasst werden können sind z.B.: TiO₂, WO₃, MoO₃, ZnO, Fe₂O₃, WS₂, MoS₂. Diese Verbindungen besitzen die elektrische Leitfähigkeit von Halbleitern.

Bei einem III-V-Verbindungshalbleiter handelt es sich um Verbindungen von Materialien der chemischen Hauptgruppe III (Erdmetalle/Borgruppe) und V (Stickstoff-Phosphor-Gruppe), deren Kombination ebenfalls die elektrische Leitfähigkeit von Halbleitern besitzen.

### Physikalische Grundlagen

- Angelagerte Moleküle beeinflussen lokal die Raumladungszone und somit die Dioden- oder Transistor-Charakteristik
- Raumladungszone erstreckt sich, je nach Ladungsträgerdichte, über/durch gesamtes Nanopartikel und beschränkt sich nicht nur auf die Randzonen der Partikel
- Kombination von Materialien mit unterschiedlichen Austrittsarbeiten und Bandlücken
   ∘ pn-Übergang unter Nutzung der grundlegenden Material-Dotierung
   ∘ Generierung eines elektrisches Signals zur direkten Auswertung
   ∘ Zwischen Nanopartikeln elektrische Übergänge mit Dioden-Charakteristik
   ∘ Angelagerte Moleküle beeinflussen lokal Raumladungszone und somit Dioden-Charakteristik
   ∘ Raumladungszone erstreckt sich, je nach Ladungsträgerdichte, über/durch gesamtes Nanopartikel

### Ausführungsbeispiele:

a) Horizontal geschichtete Nanopartikel mit pn-Übergängen in Kontaktebene
b) Kombination von nur oxidischen Materialien, um Ausheizprozesse in sauerstoffhaltiger Atmosphäre nutzen zu können
   - Halbleiterschicht mit Nanopartikeln aus z.B. TiO₂, WO₃, MoO₃, Fe₂O₃
c) Erzeugung von WO₃ aus WS₂-Flakes mit nachfolgender Oxidation
   - Dadurch flache WO₃-Bedeckung von kugeligen TiO₂-Nanopartikeln
d) Nicht-oxidische Kombination mit Halbleiterschicht WS₂, MoS₂, FeS₂
e) Kombination aus oxidischen und nicht-oxidischen Materialien

Entsprechend den Figuren 6A bis 6D sind verschieden strukturierte Ausführungen möglich, um Zugang von Molekülen zu den entsprechenden pn-Übergängen zu ermöglichen:
**Fig. 6A****.** Unstrukturierte Flächen im Sensorbereich; Kontakt (56) sollte als poröse Fläche ausgeführt sein (z.B. Metall-Nanopartikel, ITO-NP oder FTO-NP)
**Fig. 6B****.** Strukturierte Ankontaktierung (56) auf geschlossenen Schichten 13, 14, 15; Kontakt (56) muss nun nicht mehr nanoporös ausgeführt sein
**Fig. 6C****.** Strukturierung Topelektrode (56) und strukturierte oberste Halbleiterschicht (S); Halbleiter-Schicht 15 muss nun nicht mehr nanoporös ausgeführt sein
**Fig. 6D****.** Komplette Strukturierung bis auf den unteren Kontakt (52); Halbleiter-Schichten 15 und 13 müssen nun nicht mehr nanoporös ausgeführt sein

Die Erfindung schafft selbstorganisierte pn-Übergänge mit direktem Kontakt zu den zu untersuchenden Medien. Dies ermöglicht einen kostengünstigen Aufbau bei hoher Empfindlichkeit, sowie eine große aktive, innere Oberfläche durch Verwendung von Nanopartikeln. Zudem wird ein großflächiger Aufbau auf beliebigen Substraten möglich. Ferner können die im allgemeinen hohen Prozessierungstemperaturen (600 °C) für stöchiometrische Verbindungen werden. Einfache Kombination von im Allgemeinen nicht kompatiblen Verbindungen aufgrund nicht-kompatibler Herstellungsprozesse (z.B. oxidische Source/Drainschichten mit dazwischen platzierter sulfidischer Basis aus z.B. MoS₂) werden möglich.

Wichtige Anwendungen können unter anderem sein:
a) Sensorik zum empfindlichen Nachweis von Verunreinigungen in Luft und Wasser; Überprüfung von Einhaltung von Grenzwerten.
b) Basiselement einer neuromorphen Schaltung. Durch An- oder Abreicherung von Molekülen kann eine permanente Änderung des pn-Überganges bewirkt werden. Die dazu notwendige elektrochemische Reaktion wird durch das Anlegen einer Spannung gesteuert.

Die folgenden beispielhaften Aufzählungen können denkbare Ausführungsformen sein:
1. 3-dimensional angeordnete Nanopartikelstrukturen
2. Ziel: nichtlinear verstärkte elektrische Signale
3. Realisierung von elektronische Bauelement wie z.B. Dioden und Transistoren
4. Aufbau der Strukturen unter Verwendung von
   4.1. Heterogenen Elementen
   4.2. Homogenen Elementen
5. diffusionsoffene Schichten
6. Horizontal geschichtete Nanopartikel mit pn-Übergängen in Kontaktebene
   6.1. Großflächige Herstellung möglich auf beliebigen Substraten
   6.2. Verwendung von stöchiometrischen Verbindungen auch bei niedriger Herstellungstemperatur(≤ 450°C)
7. Mögliche Anwendungen:
   7.1. Verwendung als Sensor
   7.2. Nachbildung der Charakteristik von biologischer Nervenzelle

Beispielhafte Ziel-Anwendungen können u.a. sein:
- Verunreinigung von wss. Medien
   ∘ Nitrat, Phenole, Phosphate
   ∘ Organische Bestandteile
   ∘ Fluorverbindungen
- Gase von Interesse;
   ∘ oxidierend: SO₂, O₃
   ∘ reduzierend: Formaldehyd, NH₃, H₂S, Methan
   ∘ neutral: CO₂

Eine weitere beispielhafte Umsetzung kann u.a. vorsehen:
- Nichtlineare Änderung der Leitfähigkeit unter Beaufschlagung mit Analyten
   ∘ Horizontal geschichtete Nanopartikel mit Heteroübergängen in Kontaktebene
      ▪ Zunächst nur Kombination von oxidischen Materialien, um Ausheizprozesse in Atmosphäre nutzen zu können
      ▪ Sensorschicht mit Nanopartikeln aus TiO₂, WO₃, MoO₃, Fe₂O₃
      ▪ Erzeugung von WO₃ aus WS₂-Flakes mit nachfolgender Oxidation
      ▪ Erzeugung von WO₃ aus WS₂-Flakes mit nachfolgender Oxidation
      ▪ Dadurch eventuell flache WO₃-Bedeckung von kugeligen TiO₂-NP
      ▪ Nicht-oxidische Kombination mit Sensorschicht WS₂, MoS₂, FeS₂
   ∘ Sensorschicht aus Abscheidung von MoS₂ und WS₂

Einige Ausführungsbeispiele des erfindungsgemäßen Halbleiter-Strukturelements 10 führen zu folgenden Vorteilen:
- Größere Empfindlichkeit durch nicht-lineares Sensorsignal
- Selbstorganisierende Materialkompositionen mit Dioden- und Transistoreigenschaften
- Basierend auf Chalcogenid-Halbleiter-Nanopartikeln (z.B. WO₃, TiO₂, ZnO, WS₂, MoS₂, Fe₂O₃)
- Diffusionsoffene Elektroden durch Nanopartikel

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Nanopartikelbasiertes Halbleiter-Strukturelement (10), aufweisend:
eine erste Nanopartikelstruktur (11) mit einer Vielzahl von ersten Nanopartikeln (11₁, 11₂, 11₃),
eine zweite Nanopartikelstruktur (12) mit einer Vielzahl von zweiten Nanopartikeln (12₁, 12₂, 12₃),
wobei die erste Nanopartikelstruktur (11) und die zweite Nanopartikelstruktur (12) direkt aneinander angrenzend angeordnet sind, sodass zumindest ein Teil der ersten Nanopartikel (11₁, 11₂, 11₃) und zumindest ein Teil der zweiten Nanopartikel (12₁, 12₂, 12₃) in direktem Kontakt miteinander sind, und
wobei sich an den jeweiligen Kontaktpunkten von ersten und zweiten Nanopartikeln (11₁, 11₂, 11₃, 12₁, 12₂, 12₃) ein p-n-Übergang mit einer vorbestimmten Raumladungszone ausbildet.

2. Nanopartikelbasiertes Halbleiter-Strukturelement (10) gemäß Anspruch 1, wobei die erste Nanopartikelstruktur (11) und/oder die zweite Nanopartikelstruktur (12) einen diffusionsoffenen Aufbau aufweisen, in welchen Moleküle aus der Umgebung eindiffundieren können.

3. Nanopartikelbasiertes Halbleiter-Strukturelement (10) gemäß Anspruch 2, wobei das nanopartikelbasierte Halbleiter-Strukturelement (10) derart ausgestaltet ist, dass sich die vorbestimmte Raumladungszone und somit ein vorbestimmter Leitwert des nanopartikelbasierten Halbleiter-Strukturelements (10) verändert, wenn sich eindiffundierte Moleküle an der Oberfläche von in der jeweiligen Nanopartikelstruktur (11, 12) enthaltenen Nanopartikeln (11₁, 112, 11₃, 12₁, 122, 12₃) anlagern.

4. Nanopartikelbasiertes Halbleiter-Strukturelement (10) gemäß Anspruch 2 oder 3, ferner aufweisend eine Auswertevorrichtung, wobei die erste und/oder die zweite Nanopartikelstruktur (11, 12) eine elektrochemische Sensorstruktur bereitstellt, wobei Moleküle eines Analyten in diese elektrochemische Sensorstruktur eindiffundieren und sich an der Oberfläche von darin befindlichen Nanopartikeln (11₁, 11₂, 113, 12₁, 12₂, 12₃) anlagern können, um die vorbestimmte Raumladungszone und somit einen vorbestimmten Leitwert des nanopartikelbasierten Halbleiter-Strukturelements (10) zu verändern, und wobei die Auswertevorrichtung ausgestaltet ist, um basierend auf der Änderung des Leitwerts den Analyten zu bestimmen.

5. Nanopartikelbasiertes Halbleiter-Strukturelement (10) gemäß einem der Ansprüche 1 bis 4, wobei das nanopartikelbasierte Halbleiter-Strukturelement (10) ausgestaltet ist, um ein Signal mit intrinsisch nicht-linearer Verstärkung zu erzeugen.

6. Nanopartikelbasiertes Halbleiter-Strukturelement (10) gemäß einem der Ansprüche 1 bis 5, wobei die ersten Nanopartikel (11₁, 11₂, 11₃) der ersten Nanopartikelstruktur (11) und die zweiten Nanopartikel (12₁, 12₂, 12₃) der zweiten Nanopartikelstruktur (12) jeweils unterschiedliche Materialien aufweisen, die sich in der Höhe der Austrittsarbeiten für Elektronen und/oder in der Höhe der jeweiligen Bandlücke voneinander unterscheiden.

7. Nanopartikelbasiertes Halbleiter-Strukturelement (10) gemäß einem der Ansprüche 1 bis 6, wobei die ersten Nanopartikel (11₁, 11₂, 11₃) der ersten Nanopartikelstruktur (11) und die zweiten Nanopartikel (12₁, 12₂, 12₃) der zweiten Nanopartikelstruktur (12) jeweils unterschiedliche Materialien aus der chemischen Hauptgruppe VI, die auch als Chalkogene bezeichnet werden, aufweisen.

8. Nanopartikelbasiertes Halbleiter-Strukturelement (10) gemäß einem der Ansprüche 1 bis 7, wobei die ersten Nanopartikel (11₁, 11₂, 11₃) der ersten Nanopartikelstruktur (11) und die zweiten Nanopartikel (12₁, 12₂, 12₃) der zweiten Nanopartikelstruktur (12) jeweils unterschiedliche Materialverbindungen mit jeweils mindestens einem Element der chemischen Hauptgruppe VI und mindestens einem Übergangsmetall aufweisen, wobei diese Materialverbindungen auch als Chalkogenide bezeichnet werden und die elektrische Leitfähigkeit von Halbleitern aufweisen.

9. Nanopartikelbasiertes Halbleiter-Strukturelement (10) gemäß Anspruch 8, wobei die ersten Nanopartikel (11₁, 11₂, 11₃) der ersten Nanopartikelstruktur (11) und/oder die zweiten Nanopartikel (12₁, 12₂, 12₃) der zweiten Nanopartikelstruktur (12) eine oxidische Materialverbindung aus Sauerstoff und einem Übergangsmetall aufweisen.

10. Nanopartikelbasiertes Halbleiter-Strukturelement (10) gemäß einem der Ansprüche 8 oder 9, wobei die ersten Nanopartikel (11₁, 11₂, 11₃) der ersten Nanopartikelstruktur (11) und/oder die zweiten Nanopartikel (12₁, 12₂, 12₃) der zweiten Nanopartikelstruktur (12) eine sulfidische Materialverbindung aus Schwefel und einem Übergangsmetall aufweisen.

11. Nanopartikelbasiertes Halbleiter-Strukturelement (10) gemäß einem der Ansprüche 1 bis 6, wobei die ersten Nanopartikel (11₁, 11₂, 113) der ersten Nanopartikelstruktur (11) ein Material aus der chemischen Hauptgruppe III aufweisen, und wobei die zweiten Nanopartikel (12₁, 122, 12₃) der zweiten Nanopartikelstruktur (12) ein Material aus der chemischen Hauptgruppe V aufweisen.

12. Nanopartikelbasiertes Halbleiter-Strukturelement (10) gemäß einem der Ansprüche 1 bis 5, wobei die ersten Nanopartikel (11₁, 112, 11₃) der ersten Nanopartikelstruktur (11) und die zweiten Nanopartikel (12₁, 12₂, 12₃) der zweiten Nanopartikelstruktur (12) jeweils das gleiche Material, jedoch mit einer unterschiedlichen Dotierung, aufweisen.

13. Nanopartikelbasiertes Halbleiter-Strukturelement (10) gemäß Anspruch 12, wobei das gleiche Material ein Element der chemischen Hauptgruppe IV enthält

14. Nanopartikelbasiertes Halbleiter-Strukturelement (10) gemäß einem der Ansprüche 1 bis 13, wobei die erste Nanopartikelstruktur (11) und die zweite Nanopartikelstruktur (12) jeweils als eine Nanopartikelschicht ausgeführt sind, wobei diese Nanopartikelschichten in einem Schichtstapel (50) übereinander angeordnet sind.

15. Nanopartikelbasiertes Halbleiter-Strukturelement (10) gemäß Anspruch 14, ferner aufweisend eine dritte Nanopartikelschicht (13) mit einer Vielzahl von dritten Nanopartikeln (13₁, 13₂, 13₃), wobei die zweite Nanopartikelschicht (12) zwischen der ersten und der dritten Nanopartikelschicht (11, 13) angeordnet ist, und wobei sich an den jeweiligen Kontaktpunkten von zweiten und dritten Nanopartikeln (12₁, 122, 12₃, 13₁, 13₂, 13₃) ein zweiter p-n-Übergang mit einer vorbestimmten Raumladungszone ausbildet.

16. Nanopartikelbasiertes Halbleiter-Strukturelement (10) gemäß Anspruch 14 oder 15, wobei zumindest eine der ersten, zweiten und dritten Nanopartikelschichten (11, 12, 13) mittels entsprechender Strukturierung freigelegt ist, sodass sich in der Umgebung befindliche Moleküle an die jeweils freigelegte Nanopartikelschicht (11, 12, 13) anlagern können.

17. Nanopartikelbasiertes Halbleiter-Strukturelement (10) gemäß einem der Ansprüche 1 bis 16, wobei das nanopartikelbasierte Halbleiter-Strukturelement (10) eine Diodenstruktur mit einem p-n-Übergang, oder eine Transistorstruktur mit zwei p-n-Übergängen, oder eine Thyristorstruktur mit drei p-n-Übergängen bildet.

18. Sensoranordnung (60) mit einem nanopartikelbasierten Halbleiter-Strukturelement (10) gemäß einem der Ansprüche 1 bis 17.
